# EUROPÄISCHE PATENTSCHRIFT

(11) **EP 1 580 297 B1**
(45) Veröffentlichungstag und Bekanntmachung des Hinweises auf die Patenterteilung: **01.02.2017**
(21) Anmeldenummer: 05005809.8
(22) Anmeldetag: 17.03.2005
(51) Int. Cl.: C23C 14/08, C23C 14/20

(54) **Folienmaterial insbesondere für Sicherheitselemente**
Sheet material, especially for security elements
Matériau en feuille en particulier pour éléments de securité

(30) Priorität: 26.03.2004 AT 5412004
(43) Veröffentlichungstag der Anmeldung: 28.09.2005
(73) Patentinhaber: Hueck Folien Gesellschaft m.b.H., 4342 Baumgartenberg (AT)
(72) Erfinder: KASTNER, Friedrich Dr., 4710 Grieskirchen (AT); MÜLLER, Matthias, 92699 Bechtsrieth (DE)
(74) Vertreter: Landgraf, Elvira

(56) Entgegenhaltungen:
- EP-A- 0 330 733
- WO-A-02/31214
- US-A- 4 430 366

## Beschreibung

Die Erfindung betrifft ein Folienmaterial insbesondere für Sicherheitselemente mit im Durchlicht sichtbaren Aussparungen.

Aus der EP 330 733 B1 ist ein Sicherheitselement in Form eines Fadens oder Bandes zur Einbettung in Sicherheitsdokumente bekannt, das aus einer lichtdurchlässigen Kunststofffolie besteht, die mit einer opaken Beschichtung versehen ist und Aussparungen aufweist, wobei zumindest in den zu den Aussparungen deckungsgleichen Bereichen farbgebende und/oder lumineszierende Substanzen vorhanden sind, die sich unter geeigneten Lichtbedingungen von der opaken Beschichtung in farblich kontrastierender Form unterscheiden.

Aus der EP 613 786 A sind Sicherheitselemente in Form von Sicherheitsfäden bekannt, die einen überdeckten Untergrund in Form eines Rasters aufweisen, wobei Aussparungen in Form von Zeichen, Mustern oder dergleichen vorgesehen sind.

Die Patentschrift WO02/31214 A1 offenbart metallische Beschichtungen auf Folien als Sicherheitselemente.

Die Schichten bzw. die Aussparungen werden im Wesentlichen drucktechnisch, beispielsweise im Tiefdruckverfahren hergestellt. Dadurch können durch die Rasterung der Druckwerkzeuge keine homogenen Schichten erzeugt werden, wobei die Sicherheitselemente zumindest unter Vergrößerung grobkörnig und aufgerastert erscheinen. Ferner müssen dazu hochdeckende Farben oder Lacke mit großer Pigmentgröße und hoher Dichte verwendet werden, die schlecht verarbeitbar sind.

Aufgabe der Erfindung war es daher ein Sicherheitselement bereitzustellen, wobei die Optik des Sicherheitselements auch unter Vergrößerung verbessert ist und damit eine verbesserte Fälschungssicherheit erreicht wird. Ferner soll die Fälschungssicherheit zusätzlich durch spezifische verwendete Materialien verbessert werden.

Gegenstand der Erfindung ist daher ein Sicherheitselement nach Anspruch 1 und ein Verfahren zur Herstellung eines Sicherheitselements nach Anspruch 8.

Als Trägersubstrate kommen beispielsweise Trägerfolien, vorzugsweise flexible transparente oder transluzente Kunststofffolien, beispielsweise aus PI, PP, MOPP, PE, PPS, PEEK, PEK, PEI, PAEK, LCP, PEN, PBT, PET, PA, PC, COC, POM, ABS, PVC in Frage.

Die Trägerfolien weisen vorzugsweise eine Dicke von 5 - 700 µm, bevorzugt 5 - 200 µm, besonders bevorzugt 5 - 50 µm auf.

Ferner können als Trägersubstrate auch Papier oder Verbunde mit Papier, beispielsweise Verbunde mit Kunststoffen mit einem Flächengewicht von 20 - 500 g/m², vorzugsweise 40 - 200 g/m². verwendet werden.

Ferner können als Trägersubstrate Vliese, wie Endlosfaservliese, Stapelfaservliese und dergleichen, die gegebenenfalls vernadelt oder kalandriert sein können, verwendet werden.

Vorzugsweise bestehen solche Vliese aus Kunststoffen, wie PP, PET, PA, PPS und dergleichen, es können aber auch Vliese aus natürlichen, gegebenenfalls behandelten Fasern, wie Viskosefaservliese eingesetzt werden. Die eingesetzten Vliese weisen ein Flächengewicht von etwa 20 g/m² bis 500 g/m² auf.

Die Trägersubstrate können zusätzlich eine Lackschicht aufweisen, die unstrukturiert oder strukturiert, beispielsweise geprägt sein oder Beugungsgitter aufweisen kann. Die Lackschicht kann beispielsweise eine haftende Lackschicht oder eine releasefähige Transferlackschicht sein, sie kann durch Strahlung, beispielsweise UV-Strahlung, thermisch oder reaktiv vernetzt oder vernetzbar sein und zusätzliche Eigenschaften wie z.B. kratzfeste und/oder antistatische Ausrüstung oder chemische Beständigkeit besitzen. Geeignet sind sowohl wässrige als auch lösungsmittelhältige Lacksysteme, insbesondere auch Lacksysteme auf Basis PE - Acrylat, PET-Acrylat, Urethan-Acrylat, PVC, PMMA oder Epoxyacrylat.

Ferner kann das Trägersubstrat auch eine elektrisch leitfähige Polymerschicht aufweisen, beispielsweise auf Basis von Polyethylendioxythiophen oder dessen Derivaten.

Auf dieses Trägersubstrat bzw. auf gegebenenfalls darauf bereits vorhandene Beschichtungen, beispielsweise Beugungsgitter, Hologramme, gedruckte Schichten, wie Farbschichten, Beschichtungen mit optisch variablen Pigmenten und dergleichen, wird für die Herstellung einer partiellen Beschichtung ein Farbauftrag aus einer in einem Lösungsmittel löslichen Druckfarbe in Form der gewünschten Aussparungen aufgebracht.

Die Aufbringung des Farbauftrags kann durch ein beliebiges Verfahren, beispielsweise durch Tiefdruck, Flexodruck, Siebdruck, Digitaldruck und dergleichen erfolgen. Die verwendete Farbe bzw. der verwendete Farblack ist in einem Lösungsmittel, vorzugsweise in Wasser löslich, es kann jedoch auch eine in jedem beliebigen Lösungsmittel, beispielsweise in Alkohol, Estern und dergleichen lösliche Farbe verwendet werden. Die Farbe bzw. der Farblack können übliche Zusammensetzungen auf Basis von natürlichen oder künstlichen Makromolekülen sein. Die lösliche Farbe kann pigmentiert oder nicht pigmentiert sein. Als Pigmente können alle bekannten Pigmente verwendet werden. Besonders geeignet sind TiO₂, ZnS, Kaolin und dergleichen.

Anschließend. kann das bedruckte Trägersubstrat bzw bei Herstellung einer vollflächigen Beschichtung das Trägersubstrat mittels eines Inline-Plasma-(Niederdruck- oder Atmosphärenplasma-), Corona- oder Flammprozesses behandelt werden. Durch energiereiches Plasma, beispielsweise Ar- oder Ar/O₂-Plasma wird die Oberfläche gegebenenfalls von Tonungsresten der Druckfarben gereinigt. Dabei wird die bei einer partiellen Beschichtung notwendige scharfe Abgrenzung der Konturen der Aussparungen, die für die notwenige Präzision der Codierung notwendig ist, erreicht. Gleichzeitig wird die Oberfläche aktiviert. Dabei werden endständige polare Gruppen an der Oberfläche erzeugt. Dadurch wird die Haftung von Metallen und dergleichen an der Oberfläche verbessert.

Gegebenenfalls kann gleichzeitig mit der Anwendung der Plasma- bzw. Corona- oder Flammbehandlung eine dünne Metall- oder Metalloxidschicht als Haftvermittler, beispielsweise durch Sputtern oder Aufdampfen aufgebracht werden. Besonders geeignet sind dabei Cr, Al, Ag, Ti, Cu, Ta, Sn, TiO₂, Si-Oxide oder Chromoxide. Diese Haftvermittlerschicht weist im allgemeinen eine Dicke von 0,1 nm - 5nm, vorzugsweise 0,2 nm - 2nm, besonders bevorzugt 0,2 bis 1 nm auf.

Anschließend wird die eigentliche funktionelle Schicht mittels eines PVD- oder CVD-Verfahrens aufgebracht.
Geeignet sind alle Elemente, deren Verbindungen oder deren Legierungen, die als stöchiometrische oder unstöchiometrische Verbindung in einer Oxidationsstufe eine Farbe aufweisen und nicht transparent erscheinen. Geeignet sind dabei insbesondere Al, Fe, Cu, Ag oder Legierungen, wie Cu/Al-Legierungen.
Dabei wird in der Aufdampfvorrichtung das Element, die Verbindung oder die Legierung verdampft oder gesputtert und auf dem Trägersubstrat abgeschieden. Dabei wird durch gesteuerte Gaszufuhr z.B. über eine Gaslanze, beispielsweise durch Zufuhr von Sauerstoff der Oxidationsgrad bzw. der Gradient der Oxidation der Beschichtung definiert eingestellt.

So kann die Beschichtung beispielsweise durch entsprechend dosierte Sauerstoffzufuhr zu unstöchiometrischem oder stöchiometrischem Oxiden oxidiert werden, wodurch auch das Erscheinungsbild verändert wird.

So erscheint Al-oxid je nach Oxidationsstufe farbig oder schwarz (unstöchiometrisches Al-oxid). Durch gezielte Gaszufuhr kann so auch nur die Oberfläche der Al-Beschichtung oxidiert werden, während der darunterliegende Bereich als metallisches Al erhalten bleibt. Dadurch erscheint die Schicht von einer Seite betrachtet, metallisch bzw. transparent oder semitransparent, von der anderen Seite betrachtet aber schwarz bzw. farbig.
Bei der Oxidation von Fe erscheint die Beschichtung rot, Cu erscheint blau, Ag schwarz und Cu/Al zeigen je nach Oxidationsgrad ein silbriges bis kupferfarbenes Erscheinungsbild.

Als Beschichtung kommen auch nicht metallische Schichten, beispielsweise Keramiken, Silizium, Fluoreszenzpigmente und dergleichen in Frage, die mittels des beschriebenen PVD- oder CVD-Verfahrens herstellbar sind.

Durch vollständiges Aufoxidieren des Materials können transparente Schichten mit unterschiedlichen Brechungsindizess erhalten werden.

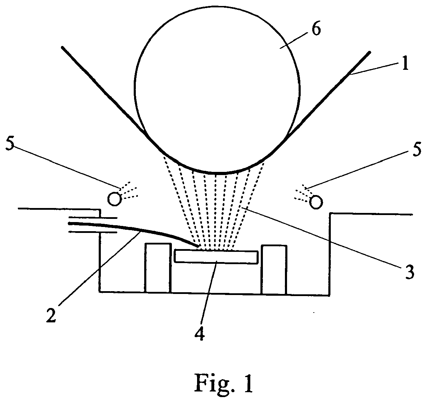

In Fig. 1 ist schematisch die Vorrichtung bzw. das Verfahren für einen PVD-Prozess zur Abscheidung der Schichten auf einem Trägersubstrat beschrieben. Dabei bedeutet 1 das Substrat, 2 das zu verdampfende und abzuscheidende Material, 3 das verdampfte Material, 4 den Verdampfer, 5 die Gaszuführung und 6 eine Kühlwalze.

So hergestellte beispielsweise schwarzfarbige Beschichtungen sind diffus streuend und stellen einen zusätzlichen Kopierschutz dar. Gleichzeitig wird die Lesbarkeit eines gegebenenfalls vorhandenen Positiv- oder Negativinformation ,da der Kontrast auch bei niedriger Schichtdicke deutlich erhöht wird und definierte hohe optische Dichte erreicht wird.

Eine silbrige Beschichtung bewirkt, dass das Sicherheitselement beispielsweise bei der Einbettung in Papier fast zu Gänze unsichtbar wird.

Anschließend wird gegebenenfalls die bei Herstellung einer partiellen Beschichtung aufgebrachte Farbschicht durch ein geeignetes Lösungsmittel, das auf die Zusammensetzung der Farbschicht abgestimmt ist, entfernt. Bevorzugt ist der Farbauftrag wasserlöslich. Gegebenenfalls kann die Ablösung durch mechanische Einwirkung unterstützt werden.

Um das Anlösen der abgedeckten Farbschicht weiter zu verbessern kann auch vollflächig oder passergenau eine dünne pigmentierte Farbschicht oder eine reine Pigmentschicht aufgebracht werden, wobei die Dicke dieser Schicht etwa 0,01 - 5 µm beträgt.

Durch das Ablösen des Farbauftrags mit den über dem Farbauftrag befindlichen Bereichen der funktionellen Schicht, wird das gewünschte Endprodukt erhalten.

Zur Herstellung einer partiellen Beschichtung können aber auch andere bekannte Strukturierungsverfahren, beispielsweise Ätzen oder die Verwendung einer Schablone im Sputter- bzw. Aufdampfverfahren eingesetzt werden.

Das beschriebene Verfahren kann gegebenenfalls auch mehrfach wiederholt werden, wobei mehrere vollflächige oder partielle Schichten mit definierten Oxidationsgradienten, die in den einzelnen Schichten auch unterschiedlich sein können, aufgebracht werden können

Auf das Trägersubstrat können anschließend weitere funktionelle und oder dekorative Schichten vollflächig oder partiell, gegebenenfalls auch passergenau oder überlappend bzw. überdeckend aufgebracht werden.
Diese weiteren Schichten beispielsweise können bestimmte chemische, physikalische und auch optische Eigenschaften aufweisen.

Die optischen Eigenschaften einer weiteren Schicht lassen sich durch sichtbare Farbstoffe bzw. Pigmente, lumineszierende Farbstoffe bzw. Pigmente, die im sichtbaren, im UV-Bereich oder im IR-Bereich fluoreszieren bzw. phosphoreszieren, Effektpigmente, wie Flüssigkristalle, Perlglanz, Bronzen und/oder Multilayer-Farbumschlagpigmente und wärmeempfindliche Farben bzw. Pigmente beeinflussen. Diese sind in allen möglichen Kombinationen einsetzbar. Zusätzlich können auch phosphoreszierende Pigmente allein oder in Kombination mit anderen Farbstoffen und/oder Pigmenten eingesetzt werden.

Ferner können auch elektrisch leitfähige Schichten auf dem Substrat vorhanden sein, oder anschließend aufgebracht werden, beispielsweise elektrisch leitfähige polymere Schichten oder leitfähige Farb- oder Lackschichten.

Zur Einstellung der elektrischen Eigenschaften können der aufzubringenden Farbe bzw. dem aufzubringenden Lack, beispielsweise Graphit, Ruß, leitfähige organische oder anorganische Polymere, Metallpigmente (beispielsweise Kupfer, Aluminium, Silber, Gold, Eisen, Chrom und dergleichen), Metalllegierungen wie Kupfer-Zink oder Kupfer-Aluminium oder auch amorphe oder kristalline keramische Pigmente wie ITO, ATO, FTO und dergleichen zugegeben werden. Weiters können auch dotierte oder nicht dotierte Halbleiter wie beispielsweise Silicium, Germanium oder dotierte oder nicht dotierte polymere Halbleiter oder Ionenleiter wie amorphe oder kristalline Metalloxide oder Metallsulfide als Zusatz verwendet werden. Ferner können zur Einstellung der elektrischen Eigenschaften der Schicht polare oder teilweise polare Verbindungen wie Tenside, oder unpolare Verbindungen wie Silikonadditive oder hygroskopische oder nicht hygroskopische Salze verwendet oder dem Lack zugesetzt werden.

Ferner kann als elektrisch leitfähige Schicht auch eine elektrisch leitfähige Polymerschicht aufgebracht werden. Die elektrisch leitfähigen Polymeren können beispielsweise Polyanilin oder Polyethylendioxythiophen und dessen Derivate sein. Besonders bevorzugt wird als elektrisch leitfähiges Polymer PEDT/TS oder PEDT-Methanol verwendet.

Zur Herstellung einer Schicht mit magnetischen Eigenschaften können paramagnetische, diamagnetische und auch ferromagnetische Stoffe, wie Eisen, Nickel und Cobalt oder deren Verbindungen oder Salze (beispielsweise Oxide oder Sulfide) oder Legierungen aus Seltenerdmetallen, wie beispielsweise Cobalt/Samarium-Legierungen verwendet werden.

Besonders geeignet sind Magnetpigmentfarben mit Pigmenten auf Basis von Fe-oxiden, Eisen, Nickel Cobalt und deren Legierungen, Barium oder Cobalt-ferrite, hart- und weich magnetische Eisen- und Stahlsorten in wässrigen bzw. lösungsmittelhaltigen Dispersionen. Als Lösungsmittel kommen beispielsweise i-Propanol, Ethylacetat, Methylethylketon, Methoxypropanol und deren Mischungen in Frage.
Vorzugsweise sind die Pigmente in Acrylat- Polymerdispersionen mit einem Molekulargewicht von 150.000 bis 300.000, in Nitrocellulose, Acrylat-Urethan Acrylat Styrol, oder PVC als Dispersionen oder in gelösten Systemen eingebracht.
Besonders geeignet zur Herstellung von Schichten mit variierbaren magnetischen Eigenschaften sind Magnetfarben, die in der Lage sind ein magnetisches Feld mit hoher Flussdichte hervorzurufen. Der messbare Gradient des magnetischen Flusses wird dann durch Dickenmodulation der magnetischen Schichten erzeugt.
Insbesondere geeignet sind Magnetfarben mit Pigmenten auf Basis von Cr/Ni-Stahl. Diese Magnetfarben zeigen im Gegensatz zu den konventionellen Magnetfarben, die schwarz, braun oder grau erscheinen, ein silbriges Erscheinungsbild und weisen gleichzeitig die oben beschriebenen erforderlichen magnetischen Eigenschaften auf.
Dadurch ist es möglich, das für viele Anwendungen erwünschte bzw. erforderliche metallisch glänzende Erscheinungsbild in einem Arbeitsgang bereits durch Verdrucken dieser Magnetfarben zu erzeugen. Ein Überdrucken bzw. Beschichten mit metallischen oder Metall-Schichten zur Erzeugung des gewünschten Erscheinungsbildes ist daher nicht nötig, kann aber beispielsweise zur Einbringung weiterer Identifikationsmerkmale problemlos erfolgen.

Es ist auch möglich der verwendeten Magnetfarbe, beispielsweise Ruß oder Graphit zuzusetzen, wodurch eine gleichzeitig magnetische als auch elektrisch leitfähige Schicht in definierter Codierung nach dem erfindungsgemäßen Verfahren besonders vorteilhaft herstellbar ist.

Ferner kommen als zusätzliche Sicherheitsmerkmale auch weitere Oberflächenreliefstrukturen, beispielsweise Beugungsgitter, Hologramme und dergleichen in Frage, wobei diese Strukturen gegebenenfalls auch metallisiert oder partiell metallisiert sein können.

Zur Herstellung derartiger Oberflächenstrukturen wird vorerst UV-härtbarer tiefziehfähiger Lack aufgebracht. Anschließend kann beispielsweise eine Oberflächenstruktur durch Abformen einer Matrize in diesen Lack, der zum Zeitpunkt der Abformung bis zum Gelpunkt vorgehärtet ist, hergestellt, worauf anschließend der strahlungshärtbare Lack nach Aufbringung der Oberflächenstruktur vollständig ausgehärtet wird.

Durch die Verwendung des UV-härtbaren Lacks sind nach der Aushärtung darauf aufgebrachte Schichten, auch eine gegebenenfalls eingebrachte Oberflächenstruktur, auch unter Temperaturbelastung stabil.

Weiters kann die erfindungsgemäße Beschichtung zusätzlich mit einer einen Farbkippeffekt hervorrufenden Schicht kombiniert sein, wobei dann die Beschichtung als elektromagnetische Wellen reflektierende Schicht fungieren kann.

Dabei weist die den Farbkippeffekt hervorrufende Beschichtung jeweils mindestens eine elektromagnetische Wellen reflektierende Schicht, eine Abstandsschicht (beispielsweise eine oder mehrere polymere Schichten) und eine Schicht, gebildet von metallischen Clustern, auf. Auf das Trägersubstrat werden eine partielle oder vollflächige elektromagnetische Wellen reflektierende Schicht, beispielsweise die erfindungsgemäße Beschichtung, und anschließend eine oder mehrere partielle und/oder vollflächige polymere Schichten definierter Dicke aufgebracht. Auf diese Abstandschicht wird eine Schicht gebildet aus metallischen Clustern, die mittels eines vakuumtechnischen Verfahrens oder aus lösungsmittelbasierten Systemen hergestellt wird, aufgebracht.
Ebenso kann ein entsprechender Farbkippeffekt durch Bedrucken mit einer Beschichtungszusammensetzung die optisch variable Pigmente aufweist, erzielt werden.
Ferner kann das Sicherheitselement auch eine Schicht mit magnetischen Eigenschaften aufweisen

Ferner können die erfindungsmäßigen Sicherheitselemente bzw. Folienmaterialien. mit einer Schutzlackschicht ein- oder beidseitig versehen sein. Der Schutzlack kann pigmentiert oder nicht pigmentiert sein, wobei als Pigmente alle bekannte Pigmente oder Farbstoffe, beispielsweise TiO₂, ZnS, Kaolin, ATO, FTO, Aluminium, Chrom- und Siliziumoxide oder beispielsweise organische Pigmente wie Pthalocyaninblau, i-Indolidgelb, Dioxazinviolett und dergleichen verwendet werden können. Ferner können lumineszierende Farbstoffe bzw. Pigmente, die im sichtbaren, im UV-Bereich oder im IR-Bereich fluoreszieren bzw. phosphoreszieren, Effektpigmente wie Flüssigkeitskristalle, Perlglanz, Bronzen und/oder Multilayer-Farbumschlagpigmente und wärmeempfindliche Farben bzw. Pigmente zugegeben werden. Diese sind in allen möglichen Kombinationen einsetzbar. Zusätzlich können auch lumineszierende Pigmente allein oder in Kombination mit anderen Farbstoffen und/oder Pigmenten eingesetzt werden.
Diese Beschichtungen können vollflächig oder partiell, beispielsweise in Form von positiven oder negativen Zeichen, Mustern, Buchstaben und dergleichen aufgebracht sein.

Das erfindungsgemäße Sicherheitselement kann ein oder beidseitig mit einer Schutzlackschicht versehen sein, die gegebenenfalls pigmentiert sein kann.

Ferner kann das erfindungsgemäße Sicherheitselement ein- oder beidseitig mit einem Heiß- oder Kaltsiegelkleber oder einer Selbstklebebeschichtung zur Aufbringung auf oder zur Einbettung in ein Substrat versehen sein, wobei diese Kleber bzw. Klebebeschichtungen pigmentiert sein können.

Ferner kann das erfindungsgemäße Sicherheitselement mit einem oder mehreren Trägersubstraten, die gegebenenfalls funktionelle und/oder dekorative Schichten aufweisen, gegebenenfalls unter Verwendung eines Kaschierklebers kaschiert sein.

Die Sicherheitselemente bzw. das Folienmaterial sind gegebenenfalls nach entsprechender Konfektionierung daher als Sicherheitsmerkmale in Datenträgern, insbesondere Wertdokumenten wie Ausweisen, Karten, Banknoten oder Etiketten, Siegeln und dergleichen geeignet, aber auch als Verpackungsmaterial beispielsweise in der pharmazeutischen, der Elektronik-und/oder Lebensmittelindustrie, beispielsweise in Form Blisterfolien, Faltschachteln, Abdeckungen, Folienverpackungen und dergleichen geeignet.

Für die Anwendung als Sicherheitsmerkmale werden die Substrate bzw. Folienmaterialien bevorzugt in Streifen oder Fäden oder Patches geschnitten, wobei die Breite der Streifen oder Fäden vorzugsweise 0,05 - 10 mm betragen kann und die Patches vorzugsweise mittlere Breiten bzw. Längen von 0,3 - 20 mm.

Für die Anwendung in oder auf Verpackungen wird das Folienmaterial bevorzugt in Streifen, Bänder, Fäden oder Patches geschnitten, wobei die Breite der der Fäden, Streifen bzw. Bänder vorzugsweise 0,05 - 50 mm beträgt und die Patches vorzugsweise mittlere Breiten und Längen von 2 - 30 mm aufweisen.

Ein entsprechender Sicherheitsfaden oder -streifen kann auch als Randverstärkung von Verpackungen, Wertdokumenten und dergleichen im Bereich der Kanten aber auch als beispielsweise Längs- oder Quer - Verstärkung in der Verpackung oder im Wertdokument verwendet werden, wobei auch jeweils mehrere Fäden oder Streifen in definiertem Abstand zueinander vorgesehen sein können.

## Patentansprüche

1. Sicherheitselement bestehend aus einem transparenten Folienmaterial das eine partielle opake Beschichtung mit Aussparungen aufweist, **dadurch gekennzeichnet, dass** die opake Beschichtung mittels eines PVD- oder CVD-Verfahrens hergestellt ist und aus einer einzigen Materialkomponente wie einem Element, einer Verbindung oder einer Legierung besteht, wobei die opake Beschichtung von unterschiedlichen Seiten des Folienmaterials betrachtet ein unterschiedliches optisches Erscheinungsbild zeigt und Aussparungen in Form von Zeichen, Buchstaben, Mustern und/oder Linien aufweist, wobei das unterschiedliche optische Erscheinungsbild durch definierte Einstellung des Gradienten der Oxidation des Elements, der Verbindung oder Legierung erzeugt ist und die opake Beschichtung auf einer Seite metallisch und auf der anderen Seite färbig oder schwarz erscheint.

2. Sicherheitselement nach Anspruch 1, **dadurch gekennzeichnet, dass** die opake Beschichtung aus mehreren Schichten mit definiertem unterschiedlichem Oxidationsgradienten besteht.

3. Sicherheitselement nach einem der Ansprüche 1 bis 2, **dadurch gekennzeichnet, dass** die Beschichtung aus Al, Fe, Cu, Ag oder einer Cu/Al-Legierung mit unterschiedlichen Oxidationsgraden oder -gradienten hergestellt ist.

4. Sicherheitselement nach einem der Ansprüche 1 bis 3, **dadurch gekennzeichnet, dass** das Folienmaterial ein- oder beidseitig mit einer Schutzlackschicht versehen ist.

5. Sicherheitselement nach einem der Ansprüche 1 bis 4, **dadurch gekennzeichnet, dass** das Folienmaterial ein- oder beidseitig mit einer Heiß-oder Kaltsiegelklebebeschichtung oder einer Selbstklebebeschichtung versehen ist.

6. Sicherheitselement nach einem der Ansprüche 1 bis 5, **dadurch gekennzeichnet, dass** das Folienmaterial mit einem oder mehreren Trägersubstraten kaschiert ist, die weitere funktionelle und/oder dekorative Schichten aufweisen können.

7. Wertdokumente oder Verpackungen, **dadurch gekennzeichnet, dass** sie ein Sicherheitselement nach einem der Ansprüche 1 bis 6 aufweisen.

8. Verfahren zur Herstellung eines Sicherheitselements nach einem der Ansprüche 1 - 7, **dadurch gekennzeichnet, dass** auf ein Trägersubstrat in einem ersten Schritt ein in einem Lösungsmittel löslicher Farbauftrag aufgebracht wird,
in einem zweiten Schritt das Trägersubstrat bzw. auf dem Trägersubstrat befindliche Schichten mittels eines Inline-Plasma-, Corona- oder Flammprozesses behandelt wird/werden und
in einem dritten Schritt eine Metallschicht aus einer Materialkomponente aufgebracht wird, deren Oxidationsgrad an der Oberfläche selektiv durch dosierte Sauerstoffzufuhr gesteuert wird,
in einem vierten Schritt der lösliche Farbauftrag zusammen mit der darüberliegenden Schicht mittels eines Lösungsmittels, kombiniert mit einer mechanischen Einwirkung entfernt wird.

9. Verfahren nach Anspruch 8, **dadurch gekennzeichnet, dass** in einem weiteren Schritt weitere Schichten mit funktionellen und/oder dekorativen Eigenschaften aufgebracht werden.

## Claims

1. Security element composed of a transparent film material which has a partial opaque coating with cutouts, **characterized in that** the opaque coating has been produced by means of a PVD process or CVD process and is composed of a single material component such as an element, a compound or an alloy, wherein the opaque coating exhibits a different optical appearance when observed from different sides of the film material and has cutouts in the form of signs, letters, patterns and/or lines, wherein the different optical appearance is produced via defined adjustment of the gradients of oxidation of the element or the compound or alloy, and the opaque coating appears metallic on one side and coloured or black on the other side.

2. Security element according to Claim 1, **characterized in that** the opaque coating is composed of a plurality of layers with defined different oxidation gradient.

3. Security element according to Claim 1 or 2, **characterized in that** the coating has been produced from Al, Fe, Cu or Ag or from a Cu/Al alloy with different oxidation levels or oxidation gradients.

4. Security element according to any of Claims 1 to 3, **characterized in that** a protective lacquer layer has been provided to one or both sides of the film material.

5. Security element according to any of Claims 1 to 4, **characterized in that** a heat- or cold-sealable adhesive coating or a self-adhesive coating has been provided to one or both sides of the film material.

6. Security element according to any of Claims 1 to 5, **characterized in that** the film material has been laminated with one or more supportive substrates which can have other functional and/or decorative layers.

7. Documents of value or packaging, **characterized in that** they comprise a security element according to any of Claims 1 to 6.

8. Process for the production of a security element according to any of Claims 1 to 7, **characterized in that** in a first step an ink soluble in a solvent is applied to a supportive substrate,
in a second step the supportive substrate, or layers located on the supportive substrate, is/are treated by means of an in-line plasma process, a corona process or a flame process, and
in a third step a metal layer is applied, made of a material component of which the oxidation level is selectively controlled at the surface via metered introduction of oxygen,
and in a fourth step the soluble ink together with the layer situated thereabove is removed by means of a solvent in combination with a mechanical effect.

9. Process according to Claim 8, **characterized in that** in a further step further layers with functional and/or decorative properties are applied.

## Revendications

1. Elément de sécurité constitué d'un matériau pelliculaire transparent, qui présente un revêtement en partie opaque avec des évidements, **caractérisé en ce que** le revêtement opaque est fabriqué au moyen d'un procédé PVD (par dépôt physique en phase vapeur) ou CVD (par dépôt chimique en phase vapeur) et est constitué d'un unique composant de matériau tel qu'un élément, un composé ou un alliage, dans lequel le revêtement opaque, observé depuis différents côtés du matériau pelliculaire, affiche un aspect optique différent et présente des évidements sous la forme de caractères, de lettres, de motifs et/ou de lignes, dans lequel l'aspect optique différent est produit par un réglage défini du gradient de l'oxydation de l'élément, du composé ou de l'alliage et le revêtement opaque paraît sur un côté métallique et sur l'autre côté coloré ou noir.

2. Elément de sécurité selon la revendication 1, **caractérisé en ce que** le revêtement opaque est constitué de plusieurs couches présentant un gradient d'oxydation différent défini.

3. Elément de sécurité selon l'une quelconque des revendications 1 à 2,
**caractérisé en ce que** le revêtement est fabriqué à partir de Al, Fe, Cu, Ag ou d'un alliage de Cu/Al présentant des degrés ou des gradients d'oxydation différents.

4. Elément de sécurité selon l'une quelconque des revendications 1 à 3,
**caractérisé en ce que** le matériau pelliculaire est pourvu d'un côté ou des deux côtés d'une couche de vernis de protection.

5. Elément de sécurité selon l'une quelconque des revendications 1 à 4,
**caractérisé en ce que** le matériau pelliculaire est pourvu d'un côté ou des deux côtés d'un revêtement collant par scellage à froid ou par scellage à chaud ou d'un revêtement autocollant.

6. Elément de sécurité selon l'une quelconque des revendications 1 à 5, **caractérisé en ce que** le matériau pelliculaire est pourvu d'un contre-collage à un ou à plusieurs substrats de support, qui peuvent présenter des couches fonctionnelles et/ou décoratives supplémentaires.

7. Documents de valeur ou emballages, **caractérisés en ce qu'**ils présentent un élément de sécurité selon l'une quelconque des revendications 1 à 6.

8. Procédé servant à fabriquer un élément de sécurité selon l'une quelconque des revendications 1 à 7, **caractérisé en ce qu'**un aplat de couleur soluble dans un solvant est appliqué sur un substrat de support lors d'une première phase,
lors d'une deuxième phase, le substrat de support ou des couches se trouvant sur le substrat de support est/sont traité(es) au moyen d'un processus plasma en ligne, d'un processus corona ou d'un processus à la flamme, et
lors d'une troisième phase, une couche de métal composée d'un composant de matériau est appliquée, dont le degré d'oxydation au niveau de la surface est commandé de manière sélective par un apport dosé en oxygène,
lors d'une quatrième phase, l'aplat de couleur soluble y compris la couche située par-dessus est retiré au moyen d'un solvant, combiné à un effet mécanique.

9. Procédé selon la revendication 8, **caractérisé en ce que** lors d'une phase supplémentaire, des couches supplémentaires présentant des propriétés fonctionnelles et/ou décoratives sont appliquées.
